# FASCICULE DE BREVET EUROPEEN

(11) **EP 3 031 076 B1**
(45) Date de publication et mention de la délivrance du brevet: **06.09.2017**
(21) Numéro de dépôt: 14747038.9
(22) Date de dépôt: 04.08.2014
(51) Int. Cl.: H01L 21/683, H01L 23/498, H01L 25/065, H01L 21/48, H01L 23/485, H01L 21/60

(54) **PROCÉDÉ DE FABRICATION D'UNE STRUCTURE SEMI-CONDUCTRICE AVEC COLLAGE TEMPORAIRE VIA DES COUCHES MÉTALLIQUES**
VERFAHREN ZUR HERSTELLUNG EINER HALBLEITERSTRUKTUR MIT VORLÄUFIGER BINDUNG DURCH METALLSCHICHTEN
PROCESS FOR MANUFACTURING A SEMICONDUCTOR STRUCTURE WITH TEMPORARY BONDING VIA METAL LAYERS

(30) Priorité: 05.08.2013 FR 1357775
(43) Date de publication de la demande: 15.06.2016
(73) Titulaire: Commissariat à l'Énergie Atomique et aux Énergies Alternatives, 75015 Paris (FR)
(72) Inventeur: GONDCHARTON, Paul, F-38100 Grenoble (FR); BENAISSA, Lamine, F-91300 Massy (FR); CHARVET, Anne-Marie, F-38450 Vif (FR); IMBERT, Bruno, F-38000 Grenoble (FR)
(74) Mandataire: Brevalex
(86) Numéro de dépôt international: PCT/EP2014/066703
(87) Numéro de publication internationale: WO 2015/018784

(56) Documents cités:
- US-A1- 2004 121 516
- US-A1- 2012 034 437

## Description

### DOMAINE TECHNIQUE

Le domaine de l'invention est celui de la réalisation de structures notamment semi-conductrices à l'aide d'un collage temporaire d'un substrat à un autre.

Des applications possibles de telles structures se retrouvent dans tous les domaines de la microtechnologie, notamment pour l'intégration 3D homogène ou hétérogène pour laquelle on cherche à empiler puis sceller des puces électroniques, les microsystèmes électromécaniques (MEMS pour *MicroElectroMechanical Systems*), les composants de puissance, photoniques, photovoltaïques.

### ÉTAT DE LA TECHNIQUE ANTÉRIEURE

Au cours de la fabrication de telles structures, utilisées notamment en microélectronique, la nécessité de devoir manipuler des couches minces entraîne des problèmes de manipulation des substrats. Notamment, si la plaque mesure moins de 150 µm d'épaisseur, elle ne peut être manipulée par des moyens classiques (tels que manuellement, par des pipettes à vides, par des précelles, par des robots, etc.) au risque de se fissurer voire de se cliver. En réalité, les substrats pour ces épaisseurs n'ont pas de tenue mécanique (à l'image d'une feuille de papier à comparer avec une feuille cartonnée).

Une solution à ce problème consiste à réaliser un collage temporaire du substrat à manipuler à un substrat poignée selon une séquence présentant:
- une étape de collage qui permet d'assembler un substrat poignée temporaire au substrat à manipuler sur lequel on souhaite par exemple réaliser des étapes technologiques spécifiques et/ou dont la manipulation classique est problématique.
- une étape de démontage qui permet de séparer ce substrat-poignée de l'assemblage pour laisser libre le substrat à manipuler pour une future intégration.

Un tel collage temporaire peut-être réalisé par collage moléculaire oxyde-oxyde ou bien à l'aide d'une colle adhésive polymère.

Dans le premier cas, l'énergie de collage d'un collage oxyde-oxyde ne fait qu'augmenter avec la température ce qui rend impossible le démontage de l'assemblage au-delà d'un certain budget thermique appliqué. En d'autre termes le substrat poignée ne devient plus un substrat temporaire mais un substrat sacrificiel qu'il est nécessaire de consommer (par exemple par rodage mécanique et/ou chimique).

Pour pallier à ce problème, des techniques consistent à inclure des couches thermiquement « fragilisables » dans l'empilement. Ces couches, par exemple des couches poreuses ou des couches implantées ioniquement, permettent le démontage mais entraînent une perte de matériaux et des coûts de production supplémentaires.

Dans le second cas, les matériaux adhésifs polymères employés peuvent devenir instables avec la température, par exemple dès 150°C. De plus, du fait de leurs propriétés mécaniques, les polymères peuvent se déformer sous l'effet de certains procédés (par exemple du fait de la pression introduite lors d'un assemblage par thermocompression) et peuvent conduire à des variations d'épaisseur d'une dizaine de microns susceptibles de poser problème pour l'uniformité des traitements appliqués aux substrats à manipuler. La nature organique de ce type de matériau pose également des problèmes de propreté (par exemple dégazage dans les chambres d'équipement, contamination des disques de polissage). Et en pratique, le démontage par dissolution du polymère n'est pas aisé pour des plaques de grand diamètre. US 2012/0034437 A1 et US 2004/0121516 A1 décrivent des procédés de réalisation d'un collage temporaire connus.

### EXPOSÉ DE L'INVENTION

L'invention vise à passer outre ces inconvénients des techniques de collage temporaire de l'état de l'art. Elle propose pour ce faire un procédé de fabrication d'une structure mettant en oeuvre un collage temporaire d'un substrat à manipuler avec un substrat poignée, tel que défini par la revendication 1.

Certains aspects préférés mais non limitatifs de procédé sont définis par les revendications dépendantes 2-15.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures 1a-1d sont des schémas illustrant les différentes étapes d'un premier mode de réalisation possible du procédé selon l'invention ;
- la figure 2 est une vue en coupe d'une interface de collage entre deux couches de cuivre présentant la même taille de grain ;
- la figure 3 est une vue en coupe de l'interface de collage de la figure 2 après d'un recuit à 400 °C pendant 1 heure ;
- les figures 4a-4f sont des schémas illustrant les différentes étapes d'un second mode de réalisation possible du procédé selon l'invention.

### EXPOSÉ DÉTAILLÉ DE MODES DE RÉALISATION PARTICULIERS

L'invention porte sur un procédé de fabrication d'une structure semiconductrice mettant en oeuvre un collage temporaire d'un substrat à manipuler avec un substrat poignée.

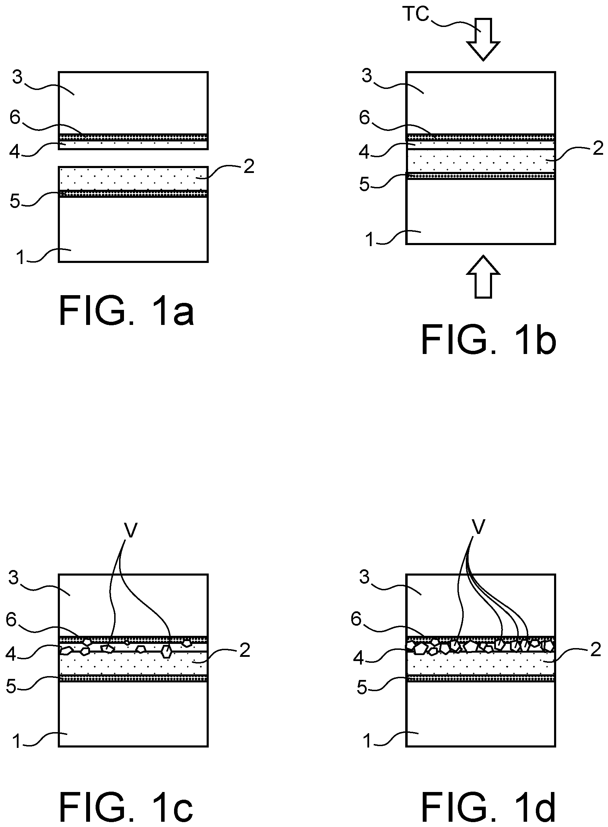

Ce procédé sera tout d'abord décrit en référence aux figures 1a-1d qui en illustrent un premier mode de réalisation possible.

En référence à la figure 1a, ce procédé comprend une étape de fourniture du substrat à manipuler 1 recouvert d'une première couche métallique 2, la première couche présentant une première taille de grain. Dans le cadre de ce premier mode de réalisation, la première couche métallique 1 est continue en ce qu'elle recouvre l'intégralité de la surface du substrat à manipuler 1.

Par taille de grain, on entend dans ce document le rayon moyen du cercle inscrit dans le grain selon le plan du substrat.

Toujours en référence à la figure 1a, le procédé comporte par ailleurs une étape de fourniture du substrat poignée 3 recouvert d'une seconde couche métallique 4, la seconde couche présentant une composition identique à la première couche (métal identique) et une seconde taille de grain différente de la première taille de grain. La seconde couche 2 est également continue.

Les première et seconde couches métalliques 2, 4 peuvent être des couches de cuivre, ce qui s'avère avantageux dans la mesure où ce matériau est largement présent sur les lignes de production microélectronique. On peut également avoir recours à des couches métalliques 2, 4 d'or, d'aluminium, de molybdène, de tungstène, etc., afin d'élargir les gammes de température accessibles pour les procédés.

Les première et seconde couches métalliques 2, 4 sont de préférence respectivement formées sur une première et une seconde sous-couches d'accroche 5, 6 interposées entre le substrat à manipuler 1 et la première couche métallique 2 d'une part et entre le substrat poignée 3 et la seconde couche métallique 4 d'autre part. Ces sous-couches d'accroche permettent le dépôt des couches métalliques.

Les sous-couches d'accroche 5, 6 sont par exemple réalisées en oxyde de silicium SiOx, nitrure de silicium SiNx, titane Ti, nitrure de titane TiN, tantale Ta, nitrure de tantale TaN, ou nitrure de tungstène WN. On choisit de préférence des sous-couches d'accroche formant en outre barrière à la diffusion du métal afin de contrecarrer la diffusion du matériau des couches métalliques 2, 4 dans les substrats 1, 3, en particulier lors d'étapes ultérieures de traitement thermique. A titre d'exemples illustratifs, une couche barrière en nitrure de titane ou en nitrure de tantale peut être interposée entre un substrat de silicium et une couche métallique de cuivre pour prévenir la diffusion du cuivre dans le silicium.

Une sous-couche d'accroche et de barrière à la diffusion du métal en nitrure de titane peut être formée par dépôt chimique en phase vapeur avec précurseurs organométalliques (MOCVD pour « MetalOrganic Chemical Vapour Deposition »), notamment sur une couche d'oxyde thermique présent en surface du substrat à manipuler ou du substrat poignée. On forme par exemple une sous-couche 5, 6 de 20 nm d'épaisseur sur un oxyde thermique de 500 nm.

Les première et seconde couches métalliques 2, 4 peuvent être formées par dépôt physique en phase vapeur (PVD pour « Physical Phase Deposition ») d'une couche germe de cuivre (« seed layer » en anglais), par exemple de 200 nm d'épaisseur. On peut procéder ensuite à un dépôt électrochimique (ECD pour « ElectroChemical Deposition ») de cuivre sur la couche germe si on souhaite augmenter l'épaisseur de la couche de cuivre.

Un recuit de recristallisation, par exemple à 400°C, peut être réalisé afin de stabiliser la microstructure des couches métalliques 2, 4 déposées sur le substrat à manipuler 1 et sur le substrat poignée 3, respectivement.

Dans le cadre de l'invention, la première couche métallique 2 et la seconde couche métallique ne présente pas la même taille de grain. La première et la seconde tailles de grain différent préférentiellement d'un facteur au moins égal à 5, plus préférentiellement au moins égal à 10, encore plus préférentiellement au moins égal à 50. On peut ainsi opter pour que l'une des première et seconde tailles de grain soit comprise entre 20 nm et 100nm, tandis que l'autre des première et seconde tailles de grain est comprise entre 5 µm et 10 µm.

La première taille de grain peut être supérieure à la seconde taille de grain. Ainsi, comme cela sera détaillé par la suite, le détachement postérieur du substrat poignée s'opère principalement du côté de la seconde couche métallique 4, plus particulièrement à l'interface sous-couche 6/seconde couche métallique 4. Cela permet de recycler plus facilement le substrat poignée. Il est possible également que la première taille de grain soit inférieure à la seconde taille de grain. Dans ce cas, on limite les opérations sur le substrat à manipuler.

L'asymétrie de tailles de grain entre les couches métalliques 2, 4 peut être induite par une asymétrie d'épaisseur entre ces couches 2, 4 obtenue par exemple en prévoyant une durée de dépôt électrochimique ECD plus importante pour l'une de ces couches. Les grains d'une couche épaisse sont effectivement plus gros que ceux d'une couche fine. On prévoit de préférence un ratio au moins égal à 5 entre les épaisseurs des couches 2, 4. A titre d'exemple illustratif, on peut prévoir une première couche métallique 2 de 5 µm d'épaisseur et une seconde couche métallique 4 de 50 nm d'épaisseur. La première taille de grain est alors de l'ordre de 5 à 10 µm, tandis que la seconde taille de grain est de l'ordre de 50 à 100 nm.

L'asymétrie de tailles de grain entre les couches métalliques 2, 4 peut également être obtenue en réalisant le dépôt des première et seconde couches métalliques sur respectivement le substrat poignée et le substrat à manipuler selon des conditions opératoires différentes. A titre d'exemple, la température du substrat pendant le dépôt de la couche germe peut être modifiée. Ou encore, la nature du bain électrolytique lors du dépôt ECD peut être modifiée.

L'asymétrie de tailles de grain entre les couches métalliques 2, 4 peut également être obtenue via le recuit de cristallisation précédemment mentionné, qui en fonction du budget thermique appliqué (couple température-durée) peut permettre d'augmenter la taille des grains dans un plan. On peut ainsi appliquer des recuits de cristallisation différents au substrat à manipuler recouvert de la première couche métallique et au substrat à manipuler recouvert d'une seconde couche métallique.

Il est bien entendu possible de combinertous ces techniques (dissymétrie en épaisseur, conditions de dépôt et et/ou de recuit) pour régler la taille respective des grains des deux couches métalliques.

En référence à la figure 1b, le procédé comporte ensuite une étape d'assemblage du substrat à manipuler 1 et du substrat poignée 3 par collage direct assisté par thermocompression TC des première et seconde couches métalliques 2, 4.

La technique du collage assisté par thermocompression permet, par l'application simultanée d'un budget thermique et d'une pression uniaxiale de part et d'autre de l'assemblage, de sceller des interfaces sans aucune préparation de surface après déposition des couches métalliques. On pourra à cet égard se référer à l'article de P. Gondcharton et al. intitulé « Mechanisms Overview of Thermocompression Process for Copper Metal Bonding », MRS Proceedings 2013.

En conséquence de l'assemblage sous thermocompression, des défauts cristallins (dislocations, lacunes, etc.) se retrouvent accumulés en forte densité dans les couches de collage. Ces défauts sont invisibles à ce stade car répartis de manière homogène dans les couches de collage. On peut penser que la pression uniaxiale appliquée à l'assemblage conduit à la déformation plastique des couches métalliques, cette déformation plastique s'accompagnant de création de défauts cristallins.

Dans un mode de réalisation possible de l'invention, la surface de l'une et/ou l'autre des couches métalliques de collage 2, 4 peut être soumise avant assemblage à un traitement de rugosification de surface. La déformation plastique ayant lieu lors du collage de surfaces rugueuses est effectivement plus importante, ce qui augmente la densité de défauts cristallins.

Dans le même ordre d'idée, on peut favoriser une thermocompression plus longue et sous pression plus importante. L'augmentation de ces deux paramètres (à température constante) favorise en effet la déformation plastique des couches métalliques de collage et augmente potentiellement la densité de défauts cristallins.

Dans un exemple de réalisation, cet assemblage est réalisé à 250°C pendant 10h sous une pression de 50 kN (1,75 MPa). Plus généralement, on réalise l'assemblage avec une température comprise entre 200 et 300°C, pendant une durée de 2 à 10 heures et une force comprise entre 50 et 100 kN pour une structure de 200mm de diamètre.

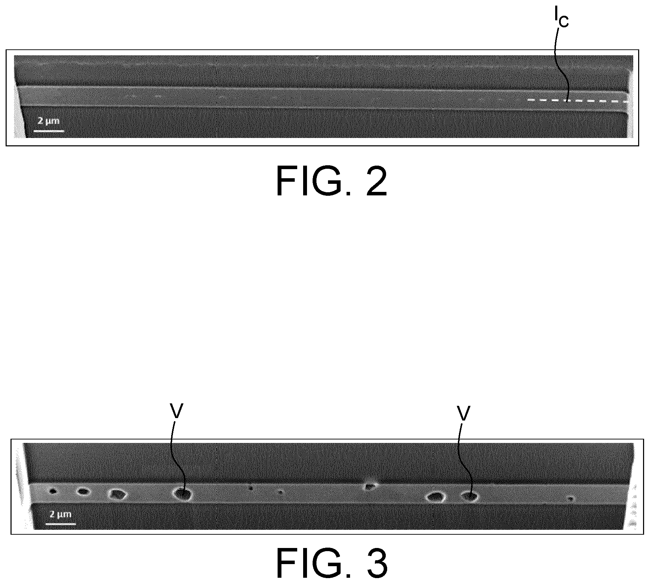

On a représenté sur la figure 2 une coupe obtenue par microscopie électronique à balayage à faisceau d'ions localisé (FIB-SEM pour « Focused Ion Beam Scanning Electron Miscroscopy ») sur une fenêtre de 40 µm de largeur de l'interface de collage Ic entre deux couches de cuivre de 1 µm présentant la même taille de grain. L'assemblage résiste à l'amincissement mécanique jusqu'à une épaisseur de 4 µm de silicium résiduel.

La figure 3 illustre quant à elle une coupe FIB-SEM sur une fenêtre de 40 µm de largeur de cette même interface de collage après application d'un recuit à 400 °C pendant 1 heure (avec des rampes de 1,7°C/min). On peut constater que le recuit a conduit à la germination et à la croissance de défauts V de quelques centaines de nanomètres de diamètre au niveau des couches de collage (appelés par la suite voids à morphologie facettée, comme dans l'article précité). On relèvera que ce recuit, appliqué à des couches métalliques de collage présentant la même taille de grain, ne conduit pas au détachement des deux substrats.

Suite au collage, le procédé selon l'invention peut comprendre une ou plusieurs étapes de traitement du substrat à manipuler, alors assemblé au substrat poignée (par exemple une fabrication de circuits microélectroniques, un amincissement, un assemblage à un substrat receveur final, etc.). Dans le cas de couches métalliques de cuivre, d'or ou d'aluminium, ces éventuels traitements peuvent notamment être réalisés dans une gamme de température située entre 30 et 350°C qui couvre les températures couramment utilisées pour les procédés classiques CMOS (« Complementary metal-oxide-semiconductor »), MEMS, etc., en particulier à des températures (notamment au-delà de 200°C) qui ne peuvent pas bénéficier d'un collage temporaire polymère du fait de son manque de stabilité en température, ou qui conduisent à une adhérence trop élevée d'un collage oxyde-oxyde pour permettre un démontage aisé. Dans le cas de couches métalliques en métal réfractaire (molybdène ou tungstène par exemple), ces éventuels traitements peuvent atteindre des températures de 900°C voire supérieures.

On retiendra par ailleurs que les propriétés mécaniques des couches minces métalliques permettent un maintien de la planéité de l'assemblage pendant des traitements entraînant des sollicitations mécaniques de l'interface (notamment en compression et en cisaillement). Des amincissements mécaniques du substrat à manipuler jusqu'à 3 µm de silicium résiduel peuvent en particulier être réalisés sans perte de planéité.

En référence aux figures 1c et 1d, le procédé selon l'invention comprend une étape de démontage de l'assemblage du substrat à manipuler et du substrat poignée pour former la structure, ledit démontage comprenant un recuit thermique de fragilisation dudit assemblage conduisant au détachement du substrat poignée. Le recuit thermique de fragilisation dudit assemblage est un traitement thermique de germination et de croissance de défauts, lesdites germination et croissance étant favorisées du côté de celle des première et seconde couches métalliques qui présente la taille de grain la plus faible.

Ce recuit thermique conduit effectivement à la réorganisation des défauts cristallins et à leur agglomération dans des sites énergétiquement favorables, pour donner naissance aux lacunes V de types voids à morphologie facettée. Comme on peut le voir sur la figure 1c, ces sites sont typiquement des points triples de joints de grains, ou des interfaces de moindre énergie (interface de collage ou interface sous-couche / dépôt métallique).

Visibles, facettés et de dimensions suffisamment importantes, ces défauts réorganisés vont permettre la perte d'adhérence entre les deux substrats. Plus précisément, la germination et à la croissance des voids V sont favorisées du côté de celle des première et seconde couches métalliques qui présente la taille de grain la plus faible. Comme illustré sur la figure 1d, la réalisation d'un collage asymétrique en taille de grain permet en effet, lors du recuit thermique de fragilisation, la germination et la croissance préférentielle des lacunes V au niveau de l'interface sous-couche / couche métallique comportant les grains les plus petits (sur les figures 1a-1d, la seconde couche métallique 4 de plus faible épaisseur) où la densité de sites préférentiels est très élevée.

Ainsi, en jouant sur la microstructure des couches métalliques à coller, l'invention permet de favoriser et de contrôler le phénomène de formation des voids V à morphologie facettée, de telle manière à permettre la formation d'une zone fragilisée entre les substrats 1, 2, voire une perte d'adhérence des substrats 1,2, en particulier une perte d'adhérence au niveau de l'interface sous-couche 6 / couche métallique 4 comportant les grains les plus petits. Pour obtenir cette perte d'adhérence, il faut que les voids soient en quantité suffisante et suffisamment localisés dans un plan parallèle au plan de la structure. Pour cela l'épaisseur cumulée de métal dans les deux couches métalliques doit être suffisante (typiquement supérieure à 300 nm dans le cas du cuivre). Cette épaisseur peut néanmoins être réduite lorsque des préparations spécifiques sont réalisées pour favoriser le développement de ces voids (notamment par rugosification avant collage).

Avantageusement pour favoriser la localisation des voids à l'interface sous-couche 6 / couche métallique 4, on choisira pour la couche 4 une épaisseur réduite par rapport à la couche 2, avantageusement au moins 5 fois plus petite. La couche la plus épaisse sert alors de « réservoir » de défauts. Par exemple on pourra prendre une couche 4 de cuivre de 50 nm d'épaisseur et une couche 2 de cuivre de 250 nm.

Dans le cas du cuivre, de l'or ou de l'aluminium, ce traitement thermique conduisant à la diminution de l'énergie de collage jusqu'à la perte d'adhérence des deux substrats peut être réalisé à une température supérieure ou égale à 400 °C, par exemple pendant une durée d'au moins dix minutes et au plus de deux heures.

Dans le cas de métaux réfractaires, ce traitement thermique peut être réalisé à une température supérieure à 900°C pendant une à deux heures par exemple.

Bien entendu, lors des étapes précédentes du procédé (thermocompression et éventuels traitements appliqués au substrat à manipuler alors assemblé au substrat poignée), le budget thermique global appliqué reste inférieur à celui appliqué lors du recuit de détachement du substrat poignée, la température restant le facteur prépondérant.

Une action mécanique (insertion d'une lame par exemple) peut éventuellement être appliquée pendant ou après le traitement thermique conduisant à la diminution de l'énergie de collage pour obtenir un détachement complet. Cette étape reste facultative car le détachement peut être obtenu du simple fait du traitement thermique.

Suite au détachement du substrat poignée, le procédé peut comporter une étape de retrait des résidus des première et seconde couches métalliques présent sur le substrat à manipuler. Ce retrait peut être réalisé par gravure chimique sélective, polissage mécano-chimique, ou tout autre procédé connu de l'homme de l'art.

Le procédé peut également comporter une étape de recyclage du substrat poignée, en vue de le rendre apte à être réutilisé dans un tel procédé de collage temporaire.

On retiendra que ces deux dernières étapes post-détachement sont beaucoup plus faciles et rentables que pour les techniques utilisant des couches « fragilisables » poreuses ou implantées ioniquement. En effet, les couches métalliques déposées peuvent être très fines, et les gravures de ces couches sont très bien maîtrisées par des technologies bon marché.

Des évaluations de l'énergie de collage ont été réalisées par la méthode DCB (« Double Cantilever Beam » ou insertion de lames) avec un collage réalisé par l'intermédiaire de couches de cuivre 5 µm et 50 nm d'épaisseur.

Après assemblage par thermocompression, l'énergie de collage est de 1400 mJ/m², correspondant à une énergie suffisante pour résister à un amincissement mécanique jusqu'à 10 µm de silicium résiduel.

Après apport d'un budget thermique à 400°C pendant deux heures, l'énergie de collage n'est plus que de 120 mJ/m², soit une énergie suffisamment faible pour permettre le démontage sans effort « à l'ongle » au niveau de l'interface sous-couche de nitrure de titane / couche de cuivre.

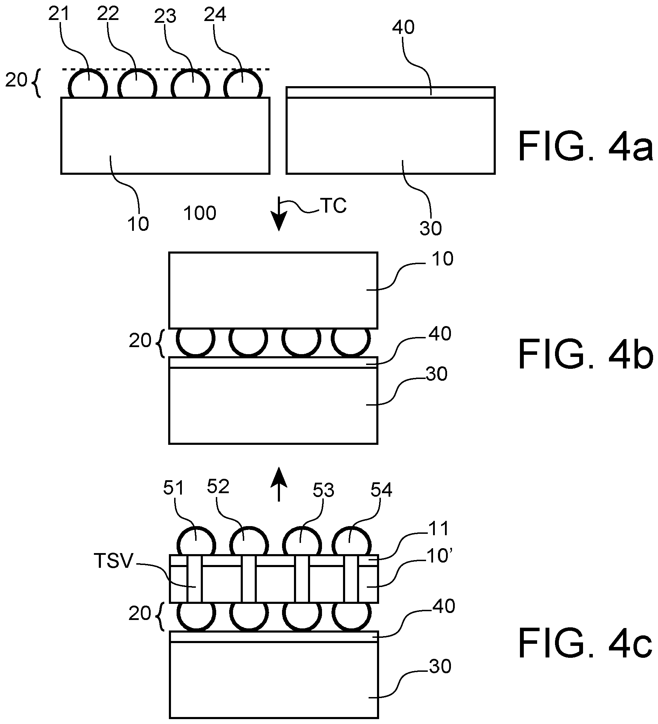

Un second mode de réalisation possible de l'invention est illustré par les figures 4a-4f. Il concerne un substrat à manipuler 10 destiné à former un substrat d'accueil (on parle alors d'« interposer » selon la terminologie anglo-saxonne) dans le cadre d'interconnexions 3D pour supporter plusieurs puces électroniques, notamment des puces hétérogènes. Le traitement du substrat à manipuler assemblé au substrat poignée consiste notamment dans ce mode de réalisation à y former des trous d'interconnexions traversant permettant d'interconnecter les deux faces de l' « interposer ».

En référence à la figure 4a, on retrouve un substrat poignée 30 recouvert d'une couche métallique continue 40, et un substrat à manipuler 10 recouvert d'une couche métallique 20 qui est ici une couche discontinue constituée d'une pluralité de micro-bosses métalliques 21-24 réparties sur le substrat à manipuler 10.

Les micro-bosses (ou « micro-bumps » selon la terminologie anglo-saxonne) sont obtenues selon un procédé classique d'étalement de résine épaisse (50 µm environ), de photolithographie, d'électrodéposition d'un métal (environ 30 µm), par exemple du cuivre, de développement de résine puis de gravure chimique métallique permettant d'obtenir le rayon de courbure souhaité. On pourra à cet égard se référer à l'article de Banijamali, B. et al. intitulé "Advanced Reliability Study of TSV Interposers and Interconnects for the 28nm Technology FPGA" (IEEE/ECTC, Orlando, Florida, June 2011, pp. 285-290).

Ces micro-bosses présentent un diamètre de l'ordre de 5 à 200 µm et sont espacées les unes des autres au minimum de quelques microns. Par ailleurs, le fait que ces micro-bosses soient réalisées à partir d'un dépôt épais de cuivre conduit à des grains de taille importante (typiquement supérieure à 5 µm). Ainsi, dans le cadre de ce mode de réalisation, la première taille de grain est supérieure à la seconde taille de grain.

En référence à la figure 4b, on procède ensuite à l'étape d'assemblage du substrat à manipuler 10 et du substrat poignée 30 par collage direct assisté par thermocompression TC des première et seconde couches métalliques 20, 40. La température est par exemple de 200°C. La pression appliquée peut être similaire à celle appliquée dans le premier mode de réalisation pour des couches continues (de l'ordre du MPa), ce qui compte tenu des surfaces en regard correspond à une force appliquée plus faible que pour des couches continues.

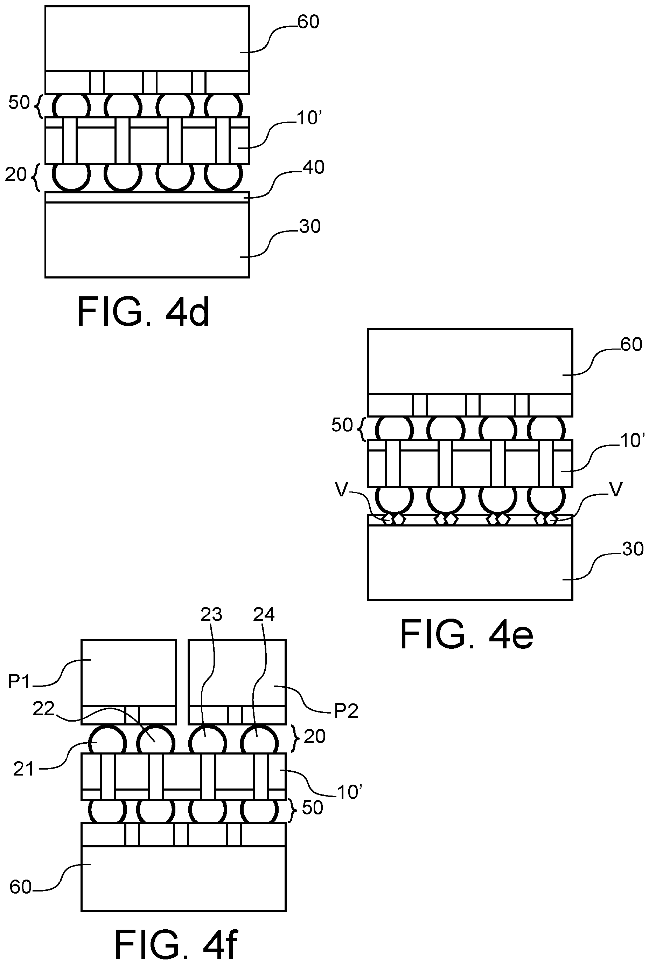

En référence aux figures 4c et 4d, on procède ensuite à un traitement du substrat à manipuler 10 alors assemblé au substrat poignée 30 à des températures comprises entre la température ambiante et 400°C.

Ce traitement peut comprendre un amincissement du substrat à manipuler, par exemple un amincissement mécanique réalisé à partir de la face libre du substrat à manipuler opposée à la face assemblée au substrat poignée, de préférence avec un contrôle de la variation maximale d'épaisseur TTV (pour « Total Thickness Variation ») afin de garantir une bonne homogénéité d'épaisseur. Le traitement peut être poursuivi par le dépôt d'une couche de passivation et d'une couche de diélectrique 11 sur le substrat à manipuler aminci 10', suivi de la formation de trous d'interconnexion TSV traversant le substrat à manipuler aminci. Un dépôt métallique peut ensuite être réalisé pourformer des bosses (ou bumps) ou des micro-bosses 51-54 sur la face libre du substrat à manipuler aminci, ces bosses ou micro-bosses pouvant être réparties selon un pas identique ou non au pas des micro-bosses 20-24 de la première couche métallique 20.

Puis en référence à la figure 4d, le traitement du substrat à manipuler assemblé au substrat poignée 30 se poursuit par un assemblage à un substrat receveur 60, plus précisément de la face libre du substrat à manipuler aminci 10', les bosses ou micro-bosses 51-54 jouant alors le rôle de couche de collage 50 avec le substrat receveur 60.

En référence à la figure 4e, on procède au démontage de l'assemblage du substrat à manipuler et du substrat poignée à l'aide d'un recuit thermique de fragilisation, par exemple réalisé à une température de 400°C. Ce recuit donne naissance aux lacunes V du côté de la seconde couche métallique 40 qui présente la taille de grain la plus faible, ces lacunes venant fragiliser l'interface entre le substrat à manipuler et le substrat poignée.

Puis en référence à la figure 4f, on vient procéder à l'assemblage de puces P1-P2, généralement hétérogènes, sur la structure formée de l'assemblage du substrat à manipuler aminci 10' (jouant ici le rôle de substrat « interposer » d'accueil), de la couche de collage 50 et du substrat receveur 60, par l'intermédiaire des micro-bosses 21-24 de la première couche métallique 20.

## Revendications

1. Procédé de fabrication d'une structure mettant en oeuvre un collage temporaire d'un substrat à manipuler (1, 10) avec un substrat poignée (3, 30), **caractérisé en ce qu'**il comporte les étapes suivantes :
- fournir le substrat à manipuler (1, 10) recouvert d'une première couche métallique (2, 20), la première couche présentant une première taille de grain correspondant au rayon moyen du cercle inscrit dans le grain selon le plan du substrat à manipuler;
- fournir le substrat poignée (3, 30) recouvert d'une seconde couche métallique (4, 40), la seconde couche présentant la même composition que la première couche métallique et une seconde taille de grain différente de la première taille de grain et correspondant au rayon moyen du cercle inscrit dans le grain selon le plan du substrat poignée;
- assemblage du substrat à manipuler (1,10) et du substrat poignée (3, 30) par collage direct assisté par thermocompression des première et seconde couches métalliques (2, 20 ; 4, 40) ;
- traitement éventuel du substrat à manipuler assemblé au substrat poignée ;
- démontage de l'assemblage du substrat à manipuler et du substrat poignée pour former la structure, ledit démontage comprenant un recuit thermique de fragilisation dudit assemblage conduisant au détachement du substrat poignée (3, 30).

2. Procédé selon la revendication 1, dans lequel la première et la seconde tailles de grain différent d'un facteur au moins égal à 5, préférentiellement au moins égal à 10, encore plus préférentiellement au moins égal à 50.

3. Procédé selon la revendication 2, dans lequel l'une des première et seconde tailles de grain est comprise entre 20 nm et 100nm et l'autre des première et seconde tailles de grain est comprise entre 5 µm et 10 µm.

4. Procédé selon l'une des revendications 1 à 3, dans lequel la première couche métallique (2) présente une épaisseur différente de la seconde couche métallique (4), les épaisseurs des première et seconde couches métalliques différant de préférence selon un ratio au moins égal à 5.

5. Procédé selon l'une des revendications 1 à 4, comprenant le dépôt des première et seconde couches métalliques sur respectivement le substrat poignée et le substrat à manipuler selon des conditions opératoires différentes.

6. Procédé selon l'une des revendications 1 et 5, comprenant, avant l'assemblage du substrat à manipuler et du substrat poignée, la mise en oeuvre de recuits de cristallisation différents du substrat à manipuler recouvert de la première couche métallique et du substrat poignée recouvert d'une seconde couche métallique.

7. Procédé selon l'une des revendications 1 à 6, comprenant, avant l'assemblage du substrat à manipuler et du substrat poignée, un traitement de rugosification de surface appliqué à au moins une des première et seconde couches métalliques.

8. Procédé selon l'une des revendications 1 à 3, dans lequel la première couche métallique (20) est une couche discontinue constituée d'une pluralité de micro-bosses métalliques (21-24) réparties sur le substrat à manipuler, la première taille de grain étant supérieure à la seconde taille de grain.

9. Procédé selon l'une des revendications 1 à 8, comprenant, après détachement du substrat poignée, un retrait des résidus des première et seconde couches métalliques présents sur le substrat à manipuler.

10. Procédé selon l'une des revendications 1 à 9, dans lequel une première couche barrière à la diffusion du métal (5) est interposée entre le substrat à manipuler (1) et la première couche métallique (3), et une seconde couche barrière à la diffusion du métal (6) est interposée entre le substrat poignée (2) et la seconde couche métallique (4).

11. Procédé selon l'une des revendications 1 à 10, dans lequel les couches métalliques étant en cuivre, le traitement du substrat à manipuler assemblé au substrat poignée est réalisé à une température supérieure à 200°C et inférieure à la température du recuit thermique de fragilisation dudit assemblage.

12. Procédé selon l'une des revendications 1 à 11, dans lequel l'assemblage du substrat à manipuler et du substrat poignée par collage direct assisté par thermocompression est réalisée à une température inférieure à la température du recuit thermique de fragilisation dudit assemblage.

13. Procédé selon l'une des revendications 1 à 12, dans lequel lorsque les couches métalliques sont en cuivre, le recuit thermique de fragilisation dudit assemblage est réalisé à une température supérieure ou égale à 400°C, et lorsque les couches métalliques sont en un métal réfractaire, le recuit thermique de fragilisation dudit assemblage est réalisé à une température supérieure ou égale à 900°C.

14. Procédé selon l'une des revendications 1 à 13, dans lequel le traitement du substrat à manipuler assemblé au substrat poignée comprend un assemblage à un substrat receveur.

15. Procédé selon la revendication 14 prise en combinaison avec la revendication 8, dans lequel le traitement du substrat à manipuler (10) assemblé au substrat poignée (30) comprend, avant assemblage à un substrat receveur, un amincissement de la face libre du substrat à manipuler et la formation de trous d'interconnexion (TSV) traversant le substrat à manipuler aminci (10').

## Patentansprüche

1. Verfahren zum Herstellen einer Struktur, bei dem ein vorläufiges Binden eines Handhabungssubstrats (1, 10) mit einem Griff-Substrat (3, 30) erfolgt, **dadurch gekennzeichnet, dass** es die nachfolgenden Schritte umfasst:
- Bereitstellen des Handhabungssubstrats (1, 10), das mit einer ersten Metallschicht (2, 20) bedeckt ist, wobei die erste Schicht eine erste Korngröße aufweist, die dem mittleren Radius des in das Korn einbeschriebenen Kreises entlang der Ebene des Handhabungssubstrats entspricht,
- Bereitstellen des Griff-Substrats (3, 30), das mit einer zweiten Metallschicht (4, 40) bedeckt ist, wobei die zweite Schicht die gleiche Zusammensetzung wie die erste Metallschicht und eine zweite Korngröße aufweist, die sich von der ersten Korngröße unterscheidet und dem mittleren Radius des in das Korn einbeschriebenen Kreises entlang der Ebene des zu Griff-Substrats entspricht,
- Zusammenfügen des Handhabungssubstrats (1, 10) und des Griff-Substrats (3, 30) durch direktes Binden unter Thermokompression der ersten und der zweiten Metallschicht (2, 20; 4, 40);
- gegebenenfalls Bearbeiten des mit dem Griff-Substrat zusammengefügten Handhabungssubstrats;
- Auseinandernehmen der Zusammenfügung aus Handhabungssubstrat und Griff-Substrat, um die Struktur zu bilden, wobei das Auseinandernehmen ein thermisches Glühen zum Verspröden der Zusammenfügung umfasst, was zum Ablösen des Griff-Substrats (3, 30) führt.

2. Verfahren nach Anspruch 1, wobei sich die erste und die zweite Korngröße um einen Faktor von zumindest gleich 5, vorzugsweise zumindest gleich 10, noch bevorzugter zumindest gleich 50, unterscheiden.

3. Verfahren nach Anspruch 2, wobei eine aus erster und zweiter Korngröße zwischen 20 nm und 10 nm und die andere aus erster und zweiter Korngröße zwischen 5 µm und 10 µm liegt.

4. Verfahren nach einem der Ansprüche 1 bis 3, wobei die erste Metallschicht (2) eine Materialstärke aufweist, die sich von der zweiten Metallschicht (4) unterscheidet, wobei sich die Materialstärken der ersten und der zweiten Metallschicht vorzugsweise in einem Verhältnis von zumindest gleich 5 unterscheiden.

5. Verfahren nach einem der Ansprüche 1 bis 4, umfassend das jeweilige Aufbringen der ersten und der zweiten Metallschicht auf das Griff-Substrat bzw. das Handhabungssubstrat nach unterschiedlichen Verfahrensbedingungen.

6. Verfahren nach einem der Ansprüche 1 und 5, umfassend vor dem Zusammenfügen des Handhabungssubstrats und des Griff-Substrats das Durchführen von unterschiedlichem Rekristallisationsglühen des mit der ersten Metallschicht bedeckten Handhabungssubstrats und des mit einer zweiten Metallschicht bedeckten Griff-Substrats.

7. Verfahren nach einem der Ansprüche 1 bis 6, umfassend vor dem Zusammenfügen des Handhabungssubstrats und des Griff-Substrats eine Bearbeitung zum Aufrauen der Oberfläche, die an zumindest einer aus erster und zweiter Metallschicht erfolgt.

8. Verfahren nach einem der Ansprüche 1 bis 3, wobei die erste Metallschicht (20) eine unterbrochene Schicht ist, die aus einer Mehrzahl von metallischen Mikroerhebungen (21 - 24) besteht, die über das Handhabungssubstrat verteilt sind, wobei die erste Korngröße größer ist als die zweite Korngröße.

9. Verfahren nach einem der Ansprüche 1 bis 8, umfassend nach dem Ablösen des Griff-Substrats ein Entfernen von an dem Handhabungssubstrat vorhandenen Rückständen der ersten und der zweiten Metallschicht.

10. Verfahren nach einem der Ansprüche 1 bis 9, wobei eine erste Metall-Diffusionssperrschicht (5) zwischen dem Handhabungssubstrat (1) und der ersten Metallschicht (3) eingefügt ist und eine zweite Metall-Diffusionssperrschicht (6) zwischen dem Griff-Substrat (2) und der zweiten Metallschicht (4) eingefügt ist.

11. Verfahren nach einem der Ansprüche 1 bis 10, wobei bei aus Kupfer bestehenden Metallschichten die Bearbeitung des mit dem Griff-Substrat zusammengefügten Handhabungssubstrats bei einer Temperatur von über 200°C und unter der Temperatur des thermischen Glühens zum Verspröden der Zusammenfügung erfolgt.

12. Verfahren nach einem der Ansprüche 1 bis 11, wobei das Zusammenfügen des Handhabungssubstrats und des Griff-Substrats durch direktes Binden unter Thermokompression bei einer Temperatur unter der Temperatur des thermischen Glühens zum Verspröden der Zusammenfügung erfolgt.

13. Verfahren nach einem der Ansprüche 1 bis 12, wobei bei aus Kupfer bestehenden Metallschichten das thermische Glühen zum Verspröden der Zusammenfügung bei einer Temperatur höher oder gleich 400°C erfolgt und bei aus hitzebeständigem Metall bestehenden Metallschichten das thermische Glühen zum Verspröden der Zusammenfügung bei einer Temperatur höher oder gleich 900°C erfolgt.

14. Verfahren nach einem der Ansprüche 1 bis 13, wobei die Bearbeitung des mit dem Griff-Substrat zusammengefügten Handhabungssubstrats eine Zusammenfügung mit einem Empfängersubstrat umfasst.

15. Verfahren nach Anspruch 14 in Kombination mit Anspruch 8, wobei die Bearbeitung des mit dem Griff-Substrat (30) zusammengefügten Handhabungssubstrats (10) vor dem Zusammenfügen mit dem Empfängersubstrat eine Einschnürung der freien Fläche des Handhabungssubstrats und das Ausbilden von Durchkontaktierungen (TSV) umfasst, die das eingeschnürte Handhabungssubstrat (10') durchsetzen.

## Claims

1. A method for manufacturing a structure which implements temporary bonding a substrate to be handled (1, 10) with a handle substrate (3, 30), **characterised in that** it includes the following steps of:
- providing the substrate to be handled (1, 10) covered with a first metal layer (2, 20), the first layer having a first grain size corresponding to the mean radius of the circle inscribed in the grain along the plane of the substrate to be handled;
- providing the handle substrate (3, 30) covered with a second metal layer (4, 40), the second layer having the same composition as the first metal layer and a second grain size different from the first grain size and corresponding to the mean radius of the circle inscribed in the grain along the plane of the handle substrate;
- assembling the substrate to be handled (1, 10) and the handle substrate (3, 30) by thermocompression assisted direct bonding of the first and second metal layers (2, 20; 4, 40);
- possibly treating the substrate to be handled while assembled to the handle substrate;
- disassembling the assembly of the substrate to be handled and the handle substrate to form the structure, said disassembling comprising an embrittlement thermal annealing of said assembly resulting in the handle substrate (3, 30) being detached.

2. The method according to claim 1, wherein the first and second grain sizes differ by a factor at least equal to 5, preferentially at least equal to 10, even more preferentially at least equal to 50.

3. The method according to claim 2, wherein one of the first and second grain sizes is between 20nm and 100nm and the other of the first and second grain sizes is between 5µm and 10µm.

4. The method according to one of claims 1 to 3, wherein the first metal layer (2) has a thickness different from the second metal layer (4), the thicknesses of the first and second metal layers preferably differing according to a ratio at least equal to 5.

5. The method according to one of claims 1 to 4, comprising depositing the first and second metal layers on the handle substrate and the substrate to be handled respectively according to different operating conditions.

6. The method according to one of claims 1 and 5, comprising, before assembling the substrate to be handled and the handle substrate, implementing different crystallization annealings of the substrate to be handled covered with the first metal layer and of the handle substrate covered with a second metal layer.

7. The method according to one of claims 1 to 6, comprising, before assembling the substrate to be handled and the handle substrate, a surface roughening treatment applied to at least one of the first and second metal layers.

8. The method according to one of claims 1 to 3, wherein the first metal layer (20) is a discontinuous layer consisting of a plurality of metal micro-bumps (21-24) distributed on the substrate to be handled, the first grain size being higher than the second grain size.

9. The method according to one of claims 1 to 8, comprising, after detaching the handle substrate, withdrawing the residues of the first and second metal layers present on the substrate to be handled.

10. The method according to one of claims 1 to 9, wherein a first metal diffusion barrier layer (5) is interposed between the substrate to be handled (1) and the first metal layer (3), and a second metal diffusion barrier layer (6) is interposed between the handle substrate (2) and the second metal layer (4).

11. The method according to one of claims 1 to 10, wherein the metal layers being of copper, the treatment of the substrate to be handled while assembled to the handle substrate is made at a temperature higher than 200°C and lower than the embrittlement thermal annealing temperature of said assembly.

12. The method according to one of claims 1 to 11, wherein the assembly of the substrate to be handled and the handle substrate by thermocompression assisted direct bonding is made at a temperature lower than the embrittlement thermal annealing temperature of said assembly.

13. The method according to one of claims 1 to 12, wherein when the metal layers are of copper, the embrittlement thermal annealing of said assembly is made at a temperature higher than or equal to 400°C, and when the metal layers are of a refractory metal, the embrittlement thermal annealing of said assembly is made at a temperature higher than or equal to 900°C.

14. The method according to one of claims 1 to 13, wherein the treatment of the substrate to be handled while assembled to the handle substrate comprises assembling to a receiver substrate.

15. The method according to claim 14 taken in combination with claim 8, wherein the treatment of the substrate to be handled (10) while assembled to the handle substrate (30) comprises, before assembling to a receiver substrate, thinning the free face of the substrate to be handled and forming through-silicon vias (TSV) passing through the thinned substrate to be handled (10').
